# FASCICULE DE BREVET EUROPEEN

(11) **EP 1 941 074 B1**
(45) Date de publication et mention de la délivrance du brevet: **07.01.2009**
(21) Numéro de dépôt: 06830990.5
(22) Date de dépôt: 23.10.2006
(51) Int. Cl.: C23C 16/513, C23C 16/04, C23C 4/00, B65D 23/02, B05D 7/22

(54) **APPAREIL REFROIDI POUR LE DÉPÔT PAR PLASMA D'UNE COUCHE BARRIÈRE SUR UN RÉCIPIENT**
GEKÜHLTE VORRICHTUNG ZUR PLASMA-ABLAGERUNG EINER SPERRSCHICHT AUF EINEM BEHÄLTER
COOLED DEVICE FOR PLASMA DEPOSITING A BARRIER LAYER ONTO A CONTAINER

(30) Priorité: 24.10.2005 FR 0510827
(43) Date de publication de la demande: 09.07.2008
(73) Titulaire: Sidel Participations, 76930 Octeville Sur Mer (FR)
(72) Inventeur: RIUS, Jean-Michel, F-76930 Octeville sur Mer (FR)
(74) Mandataire: Cabinet Plasseraud
(86) Numéro de dépôt international: PCT/FR2006/002374
(87) Numéro de publication internationale: WO 2007/048912

(56) Documents cités:
- WO-A-99/49991
- WO-A-20/04052060
- FR-A- 2 783 667
- US-A- 4 866 346
- US-B1- 6 328 805
- US-B1- 6 565 791

## Description

L'invention a trait à la fabrication des récipients, au cours de laquelle on revêt leur paroi interne d'une couche comprenant un matériau à effet barrière.

Il est connu d'effectuer le dépôt du matériau à effet barrière par plasma. Cette technologie est bien explicitée dans le brevet européen N° EP 1 068 032 au nom de la demanderesse, ou encore dans le brevet américain N° US 5 522 351.

Un appareil employé pour un tel dépôt est également décrit dans le document précité EP 1 068 032. Cet appareil comprend un générateur d'ondes électromagnétiques, une cavité reliée au générateur et réalisée dans un matériau conducteur (généralement métallique), ainsi qu'une enceinte disposée dans la cavité et réalisée dans un matériau (généralement du quartz) transparent aux ondes électromagnétiques en provenance du générateur.

Après introduction du récipient dans l'enceinte, un vide moyen (de l'ordre de 30 mbar à 100 mbar) est fait dans l'enceinte, cependant qu'un vide poussé (de quelques µbars) est fait dans le récipient. Un gaz précurseur (tel que de l'acétylène) est introduit dans le récipient, ce précurseur étant activé par bombardement électromagnétique (il s'agit généralement de micro-ondes UHF. à 2,45 GHz, de faible puissance) pour le faire passer à l'état de plasma froid et ainsi générer des espèces parmi lesquelles du carbone hydrogéné (comprenant CH, CH₂, CH₃) qui se dépose en couche mince (d'environ 60nm à 200nm) sur la paroi interne du récipient.

Le récipient à traiter est généralement réalisé dans un matériau polymère thermoplastique tel que PET (polyéthylène téréphtalate), lequel est, à 20°C, transparent aux micro-ondes électromagnétiques. Il en va de même du quartz, dont les propriétés diélectriques, favorables (à une température de l'ordre de 20°C) à la transmission des micro-ondes, le rendent particulièrement attractif pour la réalisation de l'enceinte entourant le récipient.

Dans des conditions de laboratoire, le traitement d'un récipient, incluant la mise en place du matériel puis sa mise en condition (notamment de température et de pression), peut prendre plusieurs minutes, voire plusieurs heures.

Pour une production industrielle, une série d'appareils du type précité (par exemple une vingtaine) sont montés sur un carrousel et fonctionnent en continu pour le traitement horaire de plusieurs milliers de récipients. Le temps de cycle unitaire (c'est-à-dire par appareil) est de quelques secondes.

A ce rythme, des problèmes surgissent auxquels les laborantins ne sont généralement pas confrontés. Ainsi les inventeurs ont-ils constaté, au cours du processus industriel, l'apparition d'irrégularités dans l'épaisseur de la couche barrière et de déformations sur les récipients en PET.

L'invention vise notamment à remédier à ce problème en proposant une solution permettant de garantir une meilleure répartition de la couche barrière et une réduction des déformations du récipient lors d'un traitement plasma.

A cet effet, l'invention propose un appareil pour le dépôt par plasma d'une couche mince d'un matériau à effet barrière sur une paroi interne d'un récipient, cet appareil comprenant :
- un générateur d'ondes électromagnétiques,
- une cavité reliée au générateur et réalisée dans un matériau conducteur,
- une enceinte disposée dans la cavité et réalisée dans un matériau transparent aux ondes électromagnétiques en provenance du générateur, et
- des moyens de refroidissement de l'enceinte.

A la suite d'études approfondies, les inventeurs ont formulé l'hypothèse que les irrégularités dans la couche barrière pouvaient être dues à deux phénomènes, tous deux conséquences d'une même cause.

Le premier : un échauffement intempestif des récipients au cours du processus. La transmission des micro-ondes par le PET est en effet une fonction décroissante de la température de la matière. Si à 20°C on peut considérer que le PET est totalement transparent aux micro-ondes, aux environs de 50°C cette transparence n'est plus suffisante, ce qui se traduit par une certaine inhomogénéité du plasma. Le réchauffement du récipient peut avoir une autre conséquence dans le cas des récipients à paroi dite mince (inférieure ou égale à 200 µm environ), qui tendent à se multiplier aujourd'hui avec l'accroissement du prix de la matière première (PET), issue de l'industrie chimique pétrolière : l'étirage soufflage de récipients à paroi mince génère en effet dans le récipient formé des contraintes résiduelles. En l'absence de traitement ultérieur, ces contraintes ne sont pas problématiques. En revanche, si au cours du traitement par plasma le récipient est réchauffé, les contraintes résiduelles libérées par ce réchauffement provoquent des déformations locales du récipient (d'autant plus importantes que l'on se trouve proche de la température de transition vitreuse). Il faut alors éliminer le récipient.

Les inventeurs ont supposé que cet échauffement pouvait en réalité provenir d'un échauffement de l'enceinte en quartz, le transfert de chaleur de l'enceinte au récipient s'effectuant par convection thermique. Cette supposition est audacieuse, car la pression régnant entre les parois de l'enceinte et le récipient est très faible (de l'ordre de 30 à 100 mbar, comme nous l'avons vu) par comparaison avec la pression atmosphérique.

Le deuxième phénomène est une diminution de la transparence de l'enceinte aux micro-ondes électromagnétiques, se traduisant par un bombardement inhomogène du précurseur. Les inventeurs ont supposé que la relative opacité de l'enceinte était due à l'augmentation de sa température, la présence d'impuretés dans le matériau choisi (en l'occurrence le quartz) suffisant à provoquer un réchauffement de l'enceinte sous l'action des micro-ondes électromagnétiques. Cette supposition apparaît elle aussi audacieuse, car à la connaissance des inventeurs un faible accroissement de la température d'un matériau supposé parfaitement transparent aux micro-ondes (en l'occurrence, la température de l'enceinte a été mesurée à 60°C en situation de production industrielle, tandis que cette température est de 20°C dans des conditions de laboratoire) n'avait jamais auparavant été considéré comme problématique.

La pertinence des hypothèses formulées par les inventeurs a été démontrée par la mise en oeuvre de la solution proposée : en refroidissant l'enceinte (pour la maintenir à une température inférieure à 30°C environ), on obtient effectivement une répartition plus homogène de la couche barrière, ainsi que la suppression des déformations de la bouteille.

Suivant un mode de réalisation, les moyens de refroidissement comprennent une multitude d'orifices pratiqués dans la cavité, préférentiellement orientés parallèlement les uns aux autres, par exemple suivant une direction formant un angle avec une trajectoire de l'appareil. Ces orifices permettent, lors du déplacement de l'appareil, l'établissement d'un courant d'air qui refroidit l'enceinte.

L'angle formé par l'axe des orifices avec la trajectoire de l'appareil est par exemple compris entre 5° et 45°. Un ventilateur peut en outre être disposé en amont de la cavité, face à celle-ci, pour favoriser la circulation de l'air dans la cavité autour de l'enceinte.

Les orifices sont de préférence répartis sensiblement sur toute la circonférence et/ou sensiblement sur toute la hauteur de la cavité. Par ailleurs, la densité des orifices sur la cavité est par exemple comprise entre 1/cm² et 10/cm².

Les moyens de refroidissement peuvent comprendre, en plus des orifices ou de manière alternative, un dispositif propre à générer dans l'enceinte une circulation d'air. Ce dispositif comprend par exemple un ventilateur disposé sous ou sur l'enceinte, ou encore une canalisation d'amenée d'air ainsi qu'une pompe à vide toutes deux raccordées à l'enceinte.

D'autres objets et avantages de l'invention apparaîtront à la lumière de la description faite ci-après en référence aux dessins annexés dans lesquels :
- la figure 1 est une vue d'élévation en coupe montrant un appareil pour le dépôt par plasma d'une couche barrière sur la paroi interne d'un récipient ;
- la figure 2 est une vue schématique montrant deux appareils adjacents montés sur un même carrousel ;
- la figure 3 est une vue similaire à la figure 2, suivant une variante de réalisation ;
- la figure 4 est une vue en coupe transversale partielle montrant un appareil traversé par un flux d'air ;
- la figure 5 est une vue d'élévation en coupe partielle montrant un appareil suivant une variante de réalisation ; et
- les figures 6 et 7 sont des vues de détail montrant la répartition des orifices sur la cavité, suivant deux configurations envisagées.

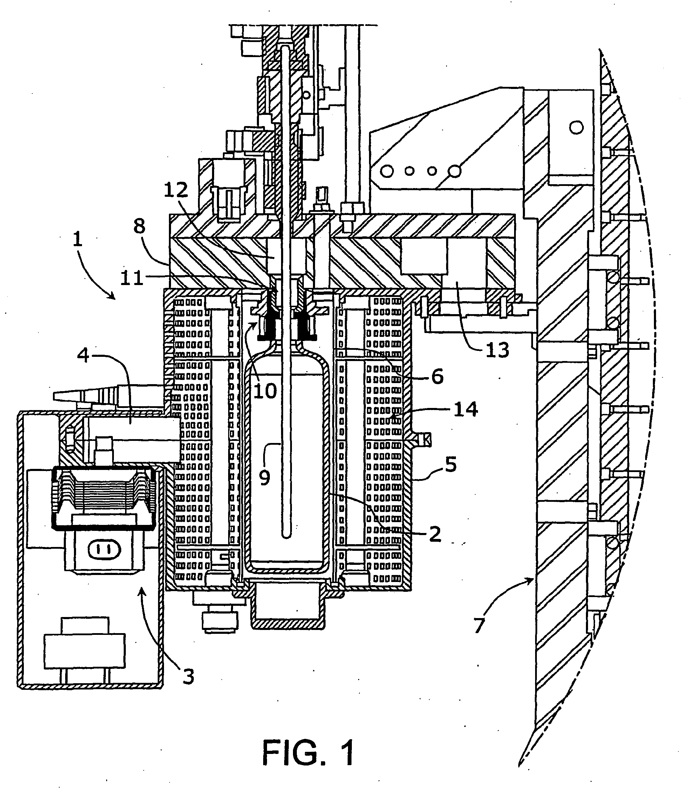

Sur la figure 1 est représenté un appareil 1 pour le dépôt par plasma d'une couche barrière sur la paroi interne d'un récipient 2 préalablement mis en forme par soufflage ou étirage soufflage à partir d'une ébauche en matière thermoplastique tel que PET.

Cet appareil 1, ci-après appelé réacteur par respect de la terminologie industrielle en vigueur, comprend un générateur 3 de micro-ondes électromagnétiques de faible puissance à une fréquence de 2,45 GHz, relié par un guide d'ondes 4 à une cavité 5 réalisée dans un matériau conducteur, par exemple en acier ou (de préférence) en aluminium ou dans un alliage d'aluminium. Dans la cavité 5 est disposée une enceinte 6 réalisée dans un matériau propre à transmettre les micro-ondes électromagnétiques, tel que du quartz. Il est à noter que l'épaisseur de la paroi de la cavité 5 est de l'ordre de 5 mm, tandis que celle de la paroi de l'enceinte 6 est comprise entre 2 et 3 mm.

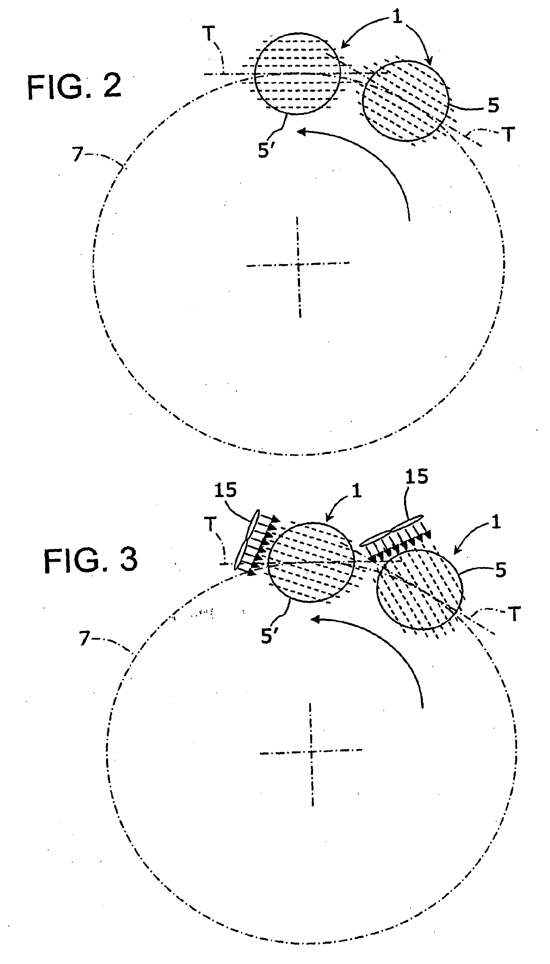

Le réacteur 1 est monté, avec une série de ses semblables, sur un carrousel 7 mis en rotation, pour le traitement simultané, entre un ou plusieurs postes de charge et un ou plusieurs postes de décharge, de plusieurs récipients 2. Ce carrousel 7 est matérialisé sur les figures 2 et 3 par sa trajectoire, circulaire, passant par les axes X des cavités 5.

La cavité 5 et l'enceinte 6 sont conjointement surmontées d'un couvercle 8 amovible permettant la mise en place étanche du récipient 2 dans l'enceinte 6. Le couvercle 8 est traversé par un injecteur 9 pour l'introduction dans le récipient 2 d'un gaz précurseur, tel que de l'acétylène. Sur le couvercle 8 est monté un support 10 auquel le récipient 2 est accroché. Ce support 10 est percé d'un trou 11 qui débouche dans une chambre 12 de post-décharge par laquelle transitent les espèces résiduelles en fin de réaction. La chambre 12 de post décharge communique avec un circuit 13 d'évacuation des espèces résiduelles, reliée à une pompe (non représentée) qui sert à la fois à établir un vide poussé (de quelques µbars) dans le récipient 2 avant l'introduction du gaz précurseur, et à pomper les espèces résiduelles en fin de réaction.

L'enceinte 6 est également reliée au circuit 13 par l'intermédiaire d'une soupape permettant d'isoler l'enceinte 6 de l'intérieur du récipient 2, après introduction de celui-ci, un vide moyen (compris entre 30 et 100 mbars) étant réalisé dans l'enceinte 6. La pression dans l'enceinte 6 dépend de l'épaisseur du récipient 2 : un vide de 100 mbars environ, qui convient pour les récipients d'épaisseur normale (aux environs de 0,35 mm), n'est pas adapté aux récipients de faible épaisseur (aux environs de 0,2 mm), le différentiel de pression entre l'intérieur et l'extérieur pouvant suffire à provoquer leur effondrement. Pour ces récipients de faible épaisseur, on établit donc le vide, dans l'enceinte, aux environs de 30 mbar.

Pour éviter le réchauffement de l'enceinte 6 et tous les inconvénients, cités en introduction, qui en découlent, chaque réacteur 1 est équipé de moyens de refroidissement de son enceinte 6.

Ces moyens de refroidissement peuvent prendre diverses formes.

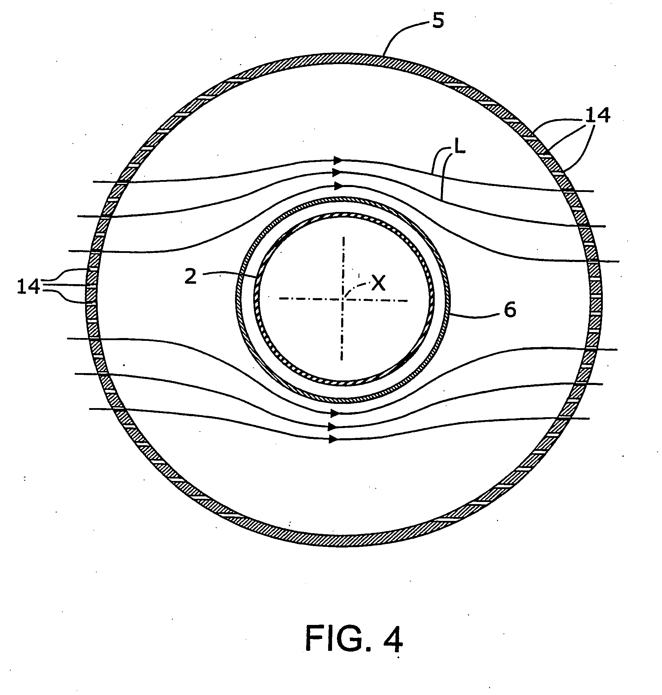

Suivant un premier mode de réalisation, l'enceinte 6 est refroidie par l'extérieur, la cavité 5 étant percée d'une multitude d'orifices 14, répartis de préférence sur toute la circonférence de la cavité 5 (ou sur une partie seulement de celle-ci), et sur toute sa hauteur (ou sur une partie seulement de celle-ci). La rotation du carrousel 7 provoque, comme illustré sur la figure 4, l'apparition dans la cavité 5 d'un courant d'air (matérialisé sur la figure 4 par des lignes de champ L) qui, la traversant de part en part, refroidit l'enceinte 6 en la maintenant à une température suffisamment faible (inférieure ou égale à 30°C) pour que la transmission des micro-ondes ne soit pas affectée et que le transfert de chaleur entre l'enceinte 6 et le récipient 2 soit suffisamment faible pour ne pas entraîner un réchauffement substantiel de celui-ci.

Les orifices 14 peuvent être à section circulaire ou rectangulaire. Leur diamètre (ou leur côté) est de préférence compris entre 1 mm et 10 mm, tandis que leur densité peut être comprise entre 1/cm² et 10/cm², selon la vitesse de rotation du carrousel 7 et l'effet de refroidissement que l'on souhaite obtenir.

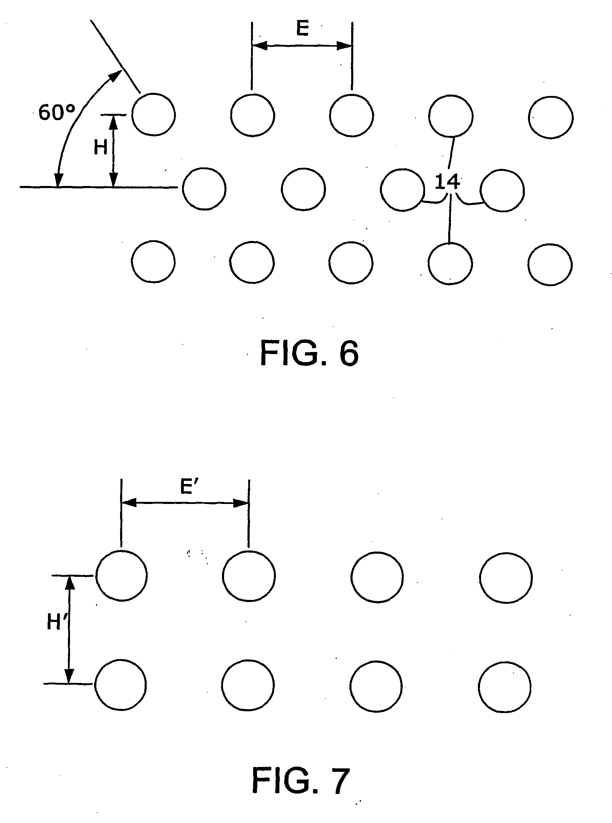

Deux exemples de motifs de distribution des orifices 14 sont donnés aux figures 6 et 7.

Suivant un premier exemple (figure 6), les orifices 14, d'un diamètre de 3 mm, sont disposées en quinconce en rangées superposées, l'écartement E entre deux orifices 14 d'une même rangée étant de 5 mm environ et la distance H séparant deux rangées adjacentes de 4,3 mm environ (en d'autre termes, l'angle entre la droite joignant les centres des orifices 14 d'une même rangée et la droite joignant les centres de deux orifices voisins de deux rangées adjacentes est de 60° environ).

Suivant un second exemple (figure 7), les orifices 14, d'un diamètre de 4 mm environ, sont disposés en damier, l'écartement E' entre deux orifices 14 voisins d'une même rangée étant de 9 mm environ, tandis que la distance H' séparant deux rangées adjacentes est de 8 mm environ.

L'orientation des orifices 14 peut être radiale ; néanmoins, pour optimiser le flux d'air il est préférable de leurs orienter parallèlement les uns aux autres. Ainsi, ils peuvent être orientés parallèlement à la tangente T locale à la trajectoire du carrousel 7 (tel que représenté sur la figure 2 où l'on a tracé des lignes en pointillés matérialisant les axes des orifices 14), où former avec celle-ci un angle en étant tournés vers l'extérieur du carrousel 7 compte tenu du sens de rotation (tel que représenté sur la figure 3), de sorte à aspirer essentiellement de l'air frais dans la cavité 5 en évitant d'aspirer de l'air chaud en provenance de la cavité 5' adjacente.

En l'absence de circulation forcée d'air, l'angle d'inclinaison des axes des orifices 14 est de préférence compris entre 5° et 45°

Toutefois, il est possible d'équiper chaque réacteur 1 d'un ventilateur 15, disposé dans l'axe des orifices 14 face à la cavité 5, devant celle-ci (c'est-à-dire en amont de celle-ci, compte tenu du sens de rotation du carrousel 7). Dans ce cas, l'angle d'inclinaison des axes des orifices 14 a une moindre importance (il est par exemple possible d'orienter les axes des orifices 14 perpendiculairement à la tangente T locale à la trajectoire), bien qu'il soit toutefois préférable que cet angle soit supérieur à 5° pour éviter l'aspiration du flux d'air chaud en provenance de la cavité 5 précédente.

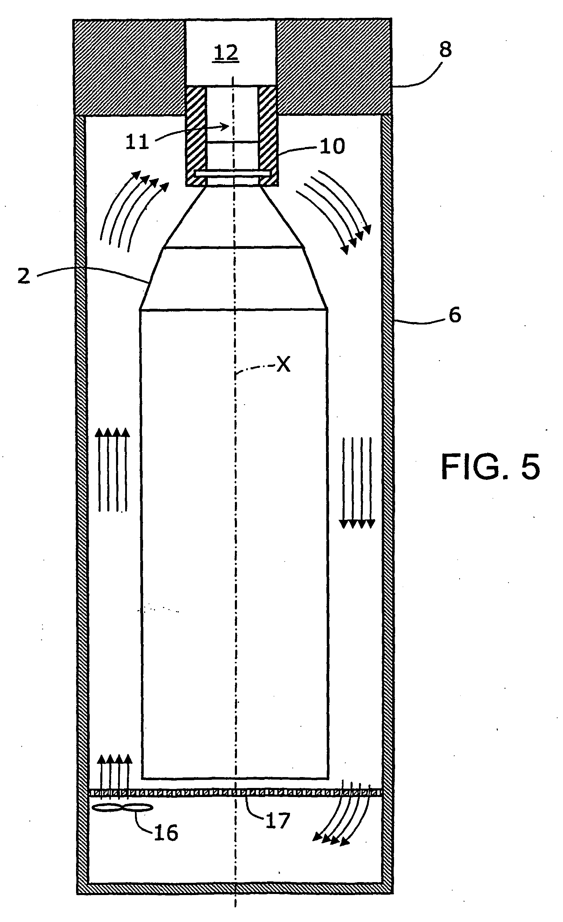

En variante, un flux d'air est généré dans l'enceinte 6 même. Ce flux peut être généré (en gardant à l'esprit que la pression dans l'enceinte est comprise entre 30 mbars et 100 mbars) par un ventilateur 16 disposé sous l'enceinte 6 et séparé de celle-ci par une grille 17 (par exemple métallique) d'isolation le préservant des effets des ondes électromagnétiques. Comme cela est illustré sur la figure 5, le ventilateur 16 est de préférence déporté vers la périphérie de l'enceinte 6, de manière à créer une circulation d'air en boucle autour du récipient 2. Dans un autre mode de réalisation, non représenté sur les figures, le ventilateur 16 peut être placé sur la partie supérieure de l'enceinte 6. Même aux pressions susdites, une telle circulation d'air apparaît suffisante pour limiter la convection thermique entre l'enceinte 6 et le récipient 2 et les maintenir tous deux à une température où une bonne transmission des micro-ondes est assurée, et où ne sont pas libérées les éventuelles contraintes résiduelles dans le récipient 2.

En variante, il est possible de générer dans l'enceinte 6 une circulation forcée par injection d'air (ou de tout autre gaz neutre) frais par une extrémité, et simultanément par pompage de l'air à une autre extrémité, de sorte à assurer le refroidissement tout en maintenant stable le vide moyen régnant dans l'enceinte 6. En pratique, il est par exemple envisageable de raccorder l'enceinte 6 d'une part (par exemple par son fond) à une canalisation d'amenée d'air, et d'autre part (par exemple par sa partie supérieure) à une pompe à vide, la régulation des débits d'alimentation et de pompage étant par exemple pilotée par rétroaction en fonction de la pression dans l'enceinte 6, qui peut être mesurée par un capteur de pression.

Les diverses dispositions qui viennent d'être décrites peuvent être combinées : on peut ainsi refroidir l'enceinte 6 à la fois par l'extérieur au moyen d'orifices dans la cavité 5, coupés ou non à un ventilateur, et par l'intérieur au moyen d'une circulation d'air soit générée par un ventilateur, soit par un dispositif d'injection et de pompage conjoints.

Quelle que soit la disposition retenue, on a constaté que le refroidissement de l'enceinte 6, par l'extérieur et/ou par l'intérieur, permet de s'affranchir des problèmes ci-dessus évoqués de mauvaise répartition de la couche barrière sur la paroi interne du récipient 2. Du moins cette répartition est-elle plus homogène que par le passé, et on constate une meilleure tenue mécanique des récipients de faible poids.

## Revendications

1. Appareil (1) pour le dépôt par plasma d'une couche mince d'un matériau à effet barrière sur une paroi interne d'un récipient (2), cet appareil (1) comprenant :
- un générateur (3) d'ondes électromagnétiques,
- une cavité (5) reliée au générateur (3) et réalisée dans un matériau conducteur, et
- une enceinte (6) disposée dans la cavité (5) et réalisée dans un matériau transparent aux ondes électromagnétiques en provenance du générateur (3) ;
cet appareil (1) étant **caractérisé en ce qu'**il comprend des moyens de refroidissement (14, 15 ; 16) de l'enceinte (6).

2. Appareil (1) selon la revendication 1, **caractérisé en ce que** les moyens de refroidissement comprennent une multitude d'orifices (14) pratiqués dans la cavité (5).

3. Appareil (1) selon la revendication 2, **caractérisé en ce que** les orifices (14) sont orientés parallèlement.

4. Appareil (1) selon la revendication 3, **caractérisé en ce que** les orifices (14) sont orientés suivant une direction formant un angle avec une trajectoire de l'appareil (1).

5. Appareil (1) selon la revendication 4, **caractérisé en ce que** ledit angle est compris entre 5 ° et 45°.

6. Appareil (1) selon l'une des revendications 2 à 5, **caractérisé en ce qu'**il comprend un ventilateur (15) disposé en amont de la cavité (5), face à celle-ci.

7. Appareil (1) selon l'une des revendications 2 à 6, **caractérisé en ce que** les orifices (14) sont répartis sensiblement sur toute la circonférence dé la cavité (5).

8. Appareil (1) selon l'une des revendications 2 à 7, **caractérisé en ce que** les orifices (14) sont répartis sensiblement sur toute la hauteur de la cavité (5).

9. Appareil (1) selon l'une des revendications 2 à 8, **caractérisé en ce que** la densité d'orifices (14) sur la cavité (5) est comprise entre 1/cm² et 10/cm².

10. Appareil (1) selon l'une des revendications 1 à 9, **caractérisé en ce que** les moyens de refroidissement comprennent un dispositif propre à générer dans l'enceinte (6) une circulation d'air.

11. Appareil (1) selon la revendication 10, **caractérisé en ce que** ledit dispositif comprend un ventilateur (16) disposé sous l'enceinte (6).

12. Appareil (1) selon la revendication 10, **caractérisé en ce que** ledit dispositif comprend une canalisation d'amenée d'air et une pompe à vide raccordées à l'enceinte (6).

## Claims

1. A device (1) for plasma depositing a thin film of a barrier material on an internal wall of a container (2), this device (1) comprising:
- an electromagnetic wave generator (3);
- a cavity (5) connected to the generator (3) and made of a conductive material; and
- a chamber (6) positioned in the cavity (5) and made of a material that is transparent to the electromagnetic waves coming from the generator (3); this device (1) being **characterized in that** it comprises means (14, 15; 16) for cooling the chamber (6).

2. The device (1) as claimed in claim 1, **characterized in that** the cooling means comprise a multitude of openings (14) made in the cavity (5).

3. The device (1) as claimed in claim 2, **characterized in that** the openings (14) are oriented parallel to one another.

4. The device (1) as claimed in claim 3, **characterized in that** the openings (14) are oriented in a direction forming an angle with a path of the device (1).

5. The device (1) as claimed in claim 4, **characterized in that** said angle is between 5° and 45°.

6. The device (1) as claimed in one of claims 2 to 5, **characterized in that** it comprises a fan (15) positioned upstream of the cavity (5), facing it.

7. The device (1) as claimed in one of claims 2 to 6, **characterized in that** the openings (14) are distributed substantially over the entire circumference of the cavity (5).

8. The device (1) as claimed in one of claims 2 to 7, **characterized in that** the openings (14) are distributed substantially over the entire height of the cavity (5).

9. The device (1) as claimed in one of claims 2 to 8, **characterized in that** the density of openings (14) over the cavity (5) is between 1/cm² and 10/cm².

10. The device (1) as claimed in one of claims 1 to 9, **characterized in that** the cooling means comprise a specific device for generating a circulation of air in the chamber (6).

11. The device (1) as claimed in claim 10, **characterized in that** said device comprises a fan (16) positioned under the chamber (6).

12. The device (1) as claimed in claim 10, **characterized in that** said device comprises air supply line and a vacuum pump connected to the chamber (6).

## Patentansprüche

1. Vorrichtung (1) zur Plasma-Ablagerung einer Dürinschicht eines Materials mit Sperrwirkung an einer Innenwand eines Behälters (2), die Vorrichtung (1) umfassend:
- einen Elektromagnetwellen-Generator (3)
- einen Hohlraum (5), der mit dem Generator (3) verbunden ist und in einem Leitermaterial ausgeführt ist, und
- eine Einfassung (6), die in dem Hohlraum (5) angeordnet und in einem gegenüber Elektromagnetwellen aus dem Generator (3) transparenten Material ausgeführt ist,
wobei die Vorrichtung (1) **dadurch gekennzeichnet ist, dass** sie eine Kühleinrichtung (14, 15, 16) für die Einfassung (6) umfasst.

2. Vorrichtung (1) gemäß Anspruch 1, **dadurch gekennzeichnet, dass** die Kühleinrichtung eine Vielzahl von im Hohlraum (5) angebrachten Öffnungen (14) umfasst.

3. Vorrichtung (1) gemäß Anspruch 2, **dadurch gekennzeichnet, dass** die Öffnungen (14) parallel orientiert sind.

4. Vorrichtung (1) gemäß Anspruch 3, **dadurch gekennzeichnet, dass** die Öffnungen (14) einer Richtung folgend orientiert sind, um einen Winkel mit einer Trajektorie der Vorrichtung (1) auszubilden.

5. Vorrichtung (1) gemäß Anspruch 4, **dadurch gekennzeichnet, dass** der Winkel zwischen 5° und 45° umfasst.

6. Vorrichtung (1) gemäß einem der Ansprüche 2 bis 5, **dadurch gekennzeichnet, dass** sie einen flussaufwärts vom Hohlraum (5) und diesem gegenüberliegend angeordneten Ventilator (15) umfasst.

7. Vorrichtung (1) gemäß einem der Ansprüche 2 bis 6, **dadurch gekennzeichnet, dass** die Öffnungen (14) merklich über den gesamten Umfang des Hohlraums (5) verteilt sind.

8. Vorrichtung (1) gemäß einem der Ansprüche 2 bis 7, **dadurch gekennzeichnet, dass** die Öffnungen (14) merklich über die gesamte Höhe des Hohlraums (5) verteilt sind.

9. Vorrichtung (1) gemäß einem der Ansprüche 2 bis 8, **dadurch gekennzeichnet, dass** die Dichte der Öffnungen (14) über dem Hohlraum (5) zwischen 1/cm2 und 10/cm2 umfasst.

10. Vorrichtung (1) gemäß einem der Ansprüche 1 bis 9, **dadurch gekennzeichnet, dass** die Kühleinrichtung einen eigenen Behälter umfasst, um in der Einfassung (6) eine Luftzirkulation zu generieren.

11. Vorrichtung (1) gemäß Anspruch 10, **dadurch gekennzeichnet, dass** der Behälter einen unterhalb der Einfassung (6) angeordneten Ventilator (16) umfasst.

12. Vorrichtung (1) gemäß Anspruch 10, **dadurch gekennzeichnet, dass** der Behälter eine Leitung zum Führen von Luft und eine an der Einfassung (6) angeschlossene Vakuumpumpe umfasst.
